# EUROPÄISCHE PATENTSCHRIFT

(11) **EP 1 328 976 B1**
(45) Veröffentlichungstag und Bekanntmachung des Hinweises auf die Patenterteilung: **09.12.2015**
(21) Anmeldenummer: 01987949.3
(22) Anmeldetag: 09.10.2001
(51) Int. Cl.: H01L 27/15, H01L 33/00, H01L 25/075

(54) **LED-MODUL**
LED MODULE
MODULE DEL

(30) Priorität: 16.10.2000 DE 10051159
(43) Veröffentlichungstag der Anmeldung: 23.07.2003
(60) Teilanmeldung: 11159384.4
(73) Patentinhaber: OSRAM Opto Semiconductors GmbH, 93055 Regensburg (DE)
(72) Erfinder: MARCHL, Werner, 93092 Barbing (DE); SPÄTH, Werner, 83607 Holzkirchen (DE); WAITL, Günter, 93049 Regensburg (DE)
(74) Vertreter: Epping - Hermann - Fischer
(86) Internationale Anmeldenummer: PCT/DE2001/003858
(87) Internationale Veröffentlichungsnummer: WO 2002/033756

(56) Entgegenhaltungen:
- EP-A- 0 351 867
- EP-A- 0 864 432
- WO-A-97/48138
- GB-A- 2 176 042
- TAKAHASHI K ET AL: "APPLICATIONS OF A HIGH DENSITY LED ARRAY UNIT FABRICATED ON A SILICON MICROREFLECTOR" IEICE TRANSACTIONS ON ELECTRONICS, INSTITUTE OF ELECTRONICS INFORMATION AND COMM. ENG. TOKYO, JP, Bd. E80-C, Nr. 2, 1. Februar 1997 (1997-02-01), Seiten 285-290, XP000773359 ISSN: 0916-8524 in der Anmeldung erwähnt

## Beschreibung

Die Erfindung betrifft ein LED-Modul (LED, light emitting diode, Leuchtdiode) nach dem Oberbegriff des Patentanspruchs 1.

LED-Module sind beispielsweise aus IEICE Trans. Electron., Vol. E80-C, No. 2, February 1997 bekannt. Beschrieben ist hierin ein LED-Modul mit einem Siliziumsubstrat, das eine Mehrzahl von geätzten Vertiefungen aufweist, in denen jeweils ein LED-Chip angeordnet ist. Die schrägstehenden Wände der Vertiefungen dienen dabei als Reflektor für die emittierte Strahlung.

Aus der Druckschrift GB 2 176 042 A ist ein Festkörper-Farbdisplay-System bekannt, bei dem LEDs, die die Primärfarben rot, grün und blau erzeugen, auf einer Leiterplatte mit leitfähigen Flächen angeordnet sind.

Für viele Anwendungen werden LED-Module mit geringen Abmessungen und hoher Leuchtdichte benötigt. Diese Module eignen sich insbesondere als Halbleiterlichtquelle in Verbindung mit abbildenden Optiken wie beispielsweise Projektoren.

Eine Erhöhung der Leuchtdichte eines LED-Moduls kann prinzipiell dadurch erreicht werden, daß die Packungsdichte der einzelnen Leuchtkörper erhöht wird, wobei zugleich die optische Ausgangsleistung beibehalten oder vergrößert wird.

Bei fortschreitender Miniaturisierung besteht ein Problem darin, die auf immer kleiner werdendem Raum entstehende elektrische Verlustwärme abzuführen.

Aufgabe der vorliegenden Erfindung ist es, ein LED-Modul mit hoher Leuchtdichte zu schaffen, das eine möglichst hohe Pakkungsdichte der einzelnen LEDs aufweist und zugleich kostengünstig herstellbar ist. Weiterhin ist es Aufgabe der Erfindung, eine Mehrfachanordnung derartiger LED-Module anzugeben. Diese Aufgabe wird durch ein LED-Modul nach Patentanspruch 1 bzw. eine Mehrfachanordnung nach Patentanspruch 28 gelöst. Vorteilhafte Weiterbildungen der Erfindung sind Gegenstand der abhängigen Ansprüche.

Erfindungsgemäß ist vorgesehen, daß eine Mehrzahl von LEDs auf einem Träger aufgebracht ist, wobei der Träger mindestens eine Halbleiterschicht enthält und die LEDs auf einer ebenen Hauptfläche des Trägers angeordnet sind. Unter "LEDs" sind hierbei vor allem LED-Chips, also Leuchtdiodenhalbleiterkörper mit Kontaktflächen, zu verstehen. Weitergehend können bei der Erfindung auch andere Strahlungsemitter verwendet werden. Dies umfaßt unter anderem neben Leuchtdioden Lumineszenzdioden im allgemeinen, beispielsweise Laserdioden und Superstrahler. Derartige Strahlungsemitter eignen sich insbesondere in Form von Halbleiterkörpern.

Zur elektrischen und thermischen Verbindung zwischen den LEDs und der Umgebung des LED-Moduls sind dabei verschiedene Strukturen vorgesehen. Die Ableitung der elektrischen Verlustwärme erfolgt hauptsächlich durch den Träger hindurch. Für die elektrische Versorgung der LEDs sind gesonderte Leitungsstrukturen, vorzugsweise auf der Oberfläche des Trägers, ausgebildet.

Mit Vorteil ist durch die Anordnung der LEDs auf einer ebenen Hauptfläche des Trägers eine besonders hohe Packungsdichte der LEDs möglich. Weiter ist so eine sehr dünne Ausführung des Trägers möglich, durch die der thermische Widerstand des Trägers reduziert und die Abführung der Verlustwärme erleichtert wird.

Als Halbleitermaterial für die Halbleiterschicht im Träger wird vorzugsweise Silizium oder Galliumarsenid verwendet. Weitergehend sind auch gut wärmeleitende, keramikartige Materialien wie beispielsweise Aluminiumnitrid oder Bornitrid oder Karbide wie beispielsweise Siliziumkarbid einsetzbar. Im folgenden sind auch diese Verbindungen sowie davon abgeleitete, bei der Herstellung von Halbleitern üblicherweise verwendete Materialien unter dem Begriff "Halbleiter" zu verstehen.

Mit Vorteil weisen solche Materialien, insbesondere Silizium, eine hohe Wärmeleitfähigkeit auf und sind daher als Material für einen wärmeabführenden Träger sehr gut geeignet. Zudem werden die genannten Materialien häufig in der Halbleiterindustrie eingesetzt und sind dort leicht verfügbar. Vorzugsweise wird der Träger auf der Seite, auf der die LEDs aufgebracht sind, von einer elektrisch isolierenden Schicht begrenzt. Dadurch wird eine Parallelschaltung der LEDs verhindert, so daß eine individuelle Verschaltung der LEDs möglich ist. Weitergehend können auch mehrere Isolationsschichten ausgebildet sein, zwischen denen elektrisch leitfähige Schichten angeordnet sind. In dieser Ausgestaltung sind mit Vorteil komplexe Verschaltungen der einzelnen Leuchtkörper realisierbar.

Die Isolierschicht kann beispielsweise mit Hilfe bekannter Verfahren in Form einer Siliziumoxid- oder Siliziumnitridschicht gebildet sein. Bevorzugt ist die Isolierschicht zweilagig ausgeführt, wobei auf eine Siliziumoxidschicht eine Siliziumnitridschicht aufgebracht ist. Diese Isolierschicht kann so dünn ausgeführt werden, daß sie die Wärmeleitfähigkeit des Trägers nicht beeinträchtigt. Weiterhin zeichnet sich eine solche Isolierschicht durch einen hohen Isolationsgrad und eine große Beständigkeit gegen Umgebungseinflüsse, insbesondere Feuchtigkeit, aus.

Auf dem Träger sind, einzelne und voneinander getrennte, leitfähige Bereiche ausgebildet, auf die die einzelnen LEDs direkt oder über Zwischenschichten aufgebracht sind. Besonders bevorzugt sind hierbei leitfähige Bereiche mit einem hohen Reflexions-vermögen, die durch Reflexion der in Richtung des Trägers abgestrahlten Strahlungsanteile die Lichtausbeute des LED-Moduls erhöhen. Als Material für solche leitfähigen Bereiche mit hohem Reflexionsvermögen eignet sich beispielsweise Aluminium.

Eine bevorzugte Ausgestaltung der Erfindung besteht darin, auf den leitfähigen Bereichen gesondert Chipanschlußbereiche auszubilden, die eine dauerhafte und sichere Befestigung der Halbleiterkörper bei gleichzeitig guter Kontaktgabe gewährleisten. Besonders geeignet sind Chipanschlußbereiche in Form eines Stapels dünner Metallschichten, wobei die einzelnen Schichten vorzugsweise Titan oder Edelmetalle wie Gold oder Platin enthalten.

Bei einer vorteilhaften Weiterbildung der Erfindung ist der Träger mit der von den LEDs abgewandten Seite auf einen Kühlkörper aufgebracht, der vorzugsweise als Metallschicht oder Metallblock ausgebildet ist. Eine solche Metallschicht weist eine sehr hohe Wärmeleitfähigkeit auf und verbessert damit die Wärmeableitung aus dem LED-Modul. Zugleich wird die mechanische Stabilität des LED-Moduls erhöht. Mit Vorteil läßt sich so ein dicht gepacktes LED-Modul mit sehr hoher Leuchtdichte und einer effizienten Wärmeabfuhr schaffen.

Als Materialien für den Kühlkörper eignen insbesondere aufgrund ihrer hohen Wärmeleitfähigkeit Kupfer oder Aluminium. Vorzugsweise ist der Kühlkörper mit dem Träger mittels einer Lötmasse oder eines wärmeleitenden Klebstoffs verbunden, wodurch ebenfalls ein guter Wärmeübergang gewährleistet ist.

Bevorzugt werden bei der Erfindung LEDs auf einem Träger montiert, die im Betrieb jeweils Licht unterschiedlicher Farbe emittieren (im folgenden auch kurz als Farbe der LED bezeichnet). Damit ist mit der Erfindung die Erzeugung von mischfarbigem Licht möglich, wobei sich die Farbe des abgestrahlten Lichts additiv aus den Farben des von den einzelnen LEDs abgestrahlten Lichts ergibt.

Mit Vorteil ist dabei die Farbe des Mischlichts durch eine entsprechend unterschiedliche Bestromung der einzelnen LEDs einstellbar.

Eine andere Möglichkeit zur Festlegung der Mischfarbe besteht darin, LEDs gleicher Farbe in jeweils verschiedener Anzahl in einem LED-Modul zu verwenden. Beide Möglichkeiten können sowohl kumulativ als auch alternativ verwendet werden, wobei letztere den Vorteil einer gleichmäßigeren Verteilung des Betriebsstroms auf die einzelnen LEDs besitzt, während erstere im Betrieb flexibler ist und eine präzisere Einstellung des Farborts ermöglicht.

Besonders bevorzugt werden LEDs, die Licht mit einer Zentralwellenlänge im roten, grünen, und blauen Spektralbereich emittieren, zusammen, beispielsweise zu gleichen Anteilen, bei der Erfindung eingesetzt. Damit wird ein LED-Modul geschaffen, das bei entsprechender Bestromung mit hoher Leuchtdichte weißes Licht emittiert. Weitergehend kann durch Variation der Bestromung der einzelnen LEDs Licht von unterschiedlicher Farbe emittiert werden, wobei der Farbraum zu großen Teilen abgedeckt ist. Insbesondere der Weißpunkt (Unbuntpunkt, Farbort x=y=z=0,33) kann sehr genau eingestellt werden. Damit ist die Erfindung als Weißlichtquelle zur Erzeugung rein weißen Lichts hoher Intensität ohne störenden Farbstich einsetzbar.

Mit großem Vorteil eignet sich dieses LED-Modul als Glühlampenersatz und kann beispielsweise als Weißlichtquelle in Projektoren verwendet werden. Hierbei sind besonders die geringen Abmessungen und die hohe Leuchtdichte des erfindungsgemäßen LED-Moduls von Vorteil.

Speziell eignet sich ein solches LED-Modul als Lichtquelle in LCD-Projektoren. Die mit der Erfindung ausgestatteten LCD-Projektoren können sehr kompakt ausgeführt werden, wobei die Lichtquelle hinsichtlich Lebensdauer, Energieverbrauch und anfallender Verlustwärme herkömmlichen Lichtquellen mit Glühdrähten überlegen ist. Aufgrund dieser Eigenschaften eignet sich die Erfindung vorzugsweise im mobilen Einsatz, beispielsweise im Kfz-Bereich.
Ein weiterer Vorteil der Erfindung besteht in der Dimmbarkeit des LED-Moduls, d.h. der Änderung der Leuchtdichte durch Variation des Betriebstroms. Im Gegensatz zu Glühdrähten tritt dabei in einem großen Leuchtdichteintervall keine wesentliche spektrale Änderung des abgestrahlten Lichts auf. Die Variation des Betriebsstroms kann dabei beispielsweise durch Pulsweitenmodulation erfolgen.

Bei einer vorteilhaften Ausgestaltung der Erfindung sind die LEDs in Form einer Matrix auf dem Träger angeordnet. Dies erlaubt eine hohe Packungsdichte der LEDs und erleichtert die automatisierte Herstellung des LED-Moduls.

Weitergehend sind die LEDs mit jeweils gleicher Farbe in einem regelmäßigen, matrixartigen Muster auf dem Träger angeordnet. Unter einer regelmäßigen Anordnung ist dabei eine Anordnung zu verstehen, die durch wiederholte Aneinanderreihung eines oder mehrerer Grundmuster entsteht. Durch eine solche Anordnung wird die Ansteuerung der LEDs vereinfacht und der Verdrahtungsaufwand bei der Herstellung reduziert.

Um eine homogene Farbmischung zu erzielen, ist es vorteilhaft, die LEDs hinsichtlich ihrer Farbe in periodisch wiederkehrender Folge in den Matrixzeilen anzuordnen, wobei vorzugsweise die LED-Anordnungen in den einzelnen Matrixzeilen gleich oder gleichartig sind.

Werden die Anordnungen in den einzelnen Matrixzeilen so aufeinander ausgerichtet, daß in den Matrixspalten jeweils LEDs der selben Farbe angeordnet sind, so können gleichfarbige LEDs jeweils einer Spalte sehr leicht in Serienschaltungen zusammengefaßt werden.

Besonders vorteilhaft ist es, die Anordnungen in den Matrixzeilen mit gerader Zeilennummer (bei fortlaufender Numerierung) um eine Spaltenbreite gegenüber den Anordnungen in den Matrixzeilen mit ungerader Zeilennummer jeweils nach links oder nach rechts zu verschieben. Dadurch werden einfarbige Spalten vermieden, die Ausbildung von Farbartefakten unterdrückt und ein besonders homogener Farbeindruck erzielt. Zugleich lassen sich die LEDs gleicher Farbe leicht durch zickzackartige Verbindungen zu Serienschaltungen zusammenfassen.

Weitere Merkmale, Vorteile und Zweckmäßigkeiten der Erfindung ergeben sich aus der nachfolgenden Beschreibung von vier Beispielen in Verbindung mit den Figuren 1 bis 4. Die Erfindung ist in den Figuren 7a und 7b dargestellt.

Es zeigen:
- Figur 1: eine schematische Schnittansicht eines ersten Beispiels eines LED-Moduls,
- Figur 2a und 2b: eine schematische Aufsicht und eine schematische Detailansicht eines zweiten Beispiels eines LED-Moduls,
- Figur 3a bis 3e: fünf Varianten einer schematischen Aufsicht eines dritten Beispiels eines LED-Moduls,
- Figur 4: eine schematische Aufsicht eines vierten Beispiels eines LED-Moduls,
- Figur 5: eine schematische Schnittansicht eines ersten Beispiels einer Mehrfachanordnung von LED-Modulen,
- Figur 6: eine schematische Schnittansicht eines zweiten Beispiels einer Mehrfachanordnung von LED-Modulen und
- Figur 7a und 7b: eine schematische Aufsicht und eine schematische Schnittansicht eines Ausführungsbeispiels eines erfindungsgemäßen Trägers mit LED-Modul.

Gleiche oder gleichwirkende Elemente sind dabei mit den selben Bezugszeichen versehen.

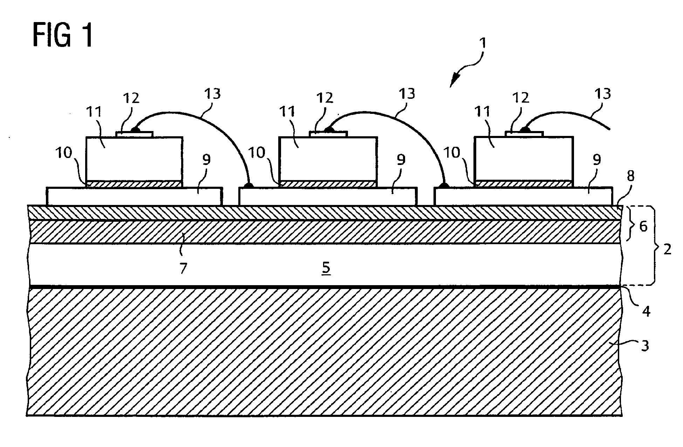

Der Träger 2 des in Figur 1 dargestellten LED-Moduls 1 weist ein entsprechend der unten beschriebenen LED-Chipanordnung strukturiertes Siliziumsubstrat 5 auf, das auf einen Kühlkörper 3 in Form eines Kupferblocks aufgelötet ist. Als Lot 4 wird ein Gold-Zinn-Lot verwendet, so daß eine mechanisch stabile Verbindung und ein effizienter Wärmeübergang zwischen dem Siliziumsubstrat 5 und dem Kupferblock 3 gewährleistet ist. Alternativ kann das Siliziumsubstrat 5 auch mittels eines wärmeleitfähigen Klebstoffs mit dem Kupferblock 3 verbunden sein.

Das Siliziumsubstrat 5 ist mehrlagig gebildet. Den Substratkörper bildet eine Schicht aus undotiertem Silizium. Darauf ist eine zweilagige Isolierschicht 6 aufgebracht, die aus einer Siliziumoxidschicht 7 und einer Siliziumnitridschicht 8 besteht, wobei die Siliziumoxidschicht 7 an den Substratkörper grenzt.

Die so gebildete, zweilagige Isolierschicht 6 ist mit den bekannten Methoden der Siliziumtechnologie leicht herstellbar und zeichnet sich neben der elektrischen Isoliereigenschaft durch große Beständigkeit, insbesondere gegen Eindringen von Feuchtigkeit aus.

Auf die Isolierschicht 6 ist eine Mehrzahl von voneinander getrennten Metallflächen 9 aufgebracht, auf denen wiederum Chipanschlußbereiche 10 ausgebildet sind. Die Metallflächen 9 bestehen vorzugsweise aus Aluminium. Ein Chipanschlußbereich 10 weist jeweils einen Stapel aus drei dünnen Metallschichten auf, die von der Seite des Siliziumsubstrats 5 aus gesehen aus Titan, Platin und Gold bestehen.

Auf die Goldoberfläche des Chipanschlußbereichs 10 ist jeweils ein LED-Halbleiterkörper 11 mittels eines leitfähigen Klebstoffs aufgeklebt. Eine Lötverbindung zwischen Halbleiterkörper 11 und Chipanschlußbereich 10 wäre ebenfalls möglich.

Zur weiteren Kontaktierung sind die Halbleiterkörper 11 auf der dem Träger 2 abgewandten Seite mit einer Kontaktfläche 12 versehen und mit Drahtverbindungen 13 untereinander verbunden. Die Aluminiumflächen 9 dienen sowohl als Drahtanschlußbereiche, die jeweils elektrisch in Verbindung mit der dem Träger 2 zugewandten Seite des aufmontierten Halbleiterkörpers 11 stehen, als auch als Reflektoren für die im Betrieb erzeugte Strahlung.

Die Dicke des Kupferblocks 3 beträgt bei dem gezeigten Ausführungsbeispiel 3,0 mm, die Dicke des Siliziumsubstrats 5 220 µm und die Dicke der Isolierschicht 6 0,62 µm. Die Aluminiumschicht 9 ist mit einer Dicke von 1,0 µm, der Chipanschlußbereich 10 mit einer Gesamtdicke von 0,3 µm ausgebildet. Mit einem 200 µm dicken Halbleiterkörper wird bei einem Rastermaß von 600 µm x 600 µm und einem Halbleiterquerschnitt von 260 µm x 260 µm insgesamt ein thermischer Widerstand von 177 K/W, bezogen auf eine Rastereinheit, erreicht.

Unter stationären Bedingungen beträgt damit bei einer typischen elektrischen Verlustleistung von 50 mW pro LED der Temperaturunterschied zwischen Halbleiteroberfläche und Trägerunterseite etwa 8,9 K (unabhängig von der Anzahl der Rastereinheiten).

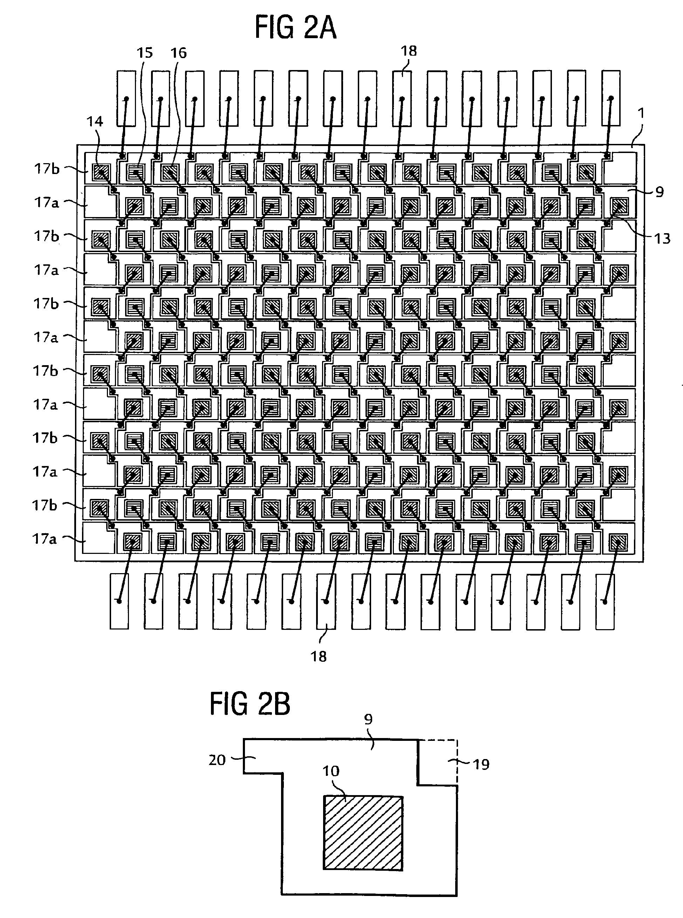

In Figur 2a ist die flächige Anordnung der LEDs in der Aufsicht gezeigt. Auf dem Träger sind insgesamt 180 LEDs 11 montiert, je 60 LEDs mit einer Zentralwellenlänge im roten, grünen und blauen Spektralbereich. Die LEDs sind in Form einer Matrix angeordnet, wobei in jeder Matrixzeile 17a,b in periodischer Folge eine rote LED 14, eine grüne LED 15 und eine blaue LED 16 nebeneinander angeordnet sind.

Die Anordnungen in den einzelnen Matrixzeilen 17a,b sind dabei so aufeinander ausgerichtet, daß die Matrixzeilen mit ungerader Zeilennummer 17b jeweils dieselbe Anordnung aufweisen und so in diesen Matrixzeilen 17b jeweils gleichfarbige LEDs untereinander angeordnet sind. Unter der Zeilennummer ist dabei die Nummer zu verstehen, die bei üblicher, fortlaufender Numerierung der Matrixzeilen von oben nach unten den einzelnen Matrixzeilen jeweils zugewiesen ist.

Die Anordnung der LEDs in den Matrixzeilen 17a mit gerader Zeilennummer entspricht der Anordnung in den Matrixzeilen 17b mit ungerader Zeilennummer, ist jedoch gegenüber den Matrixzeilen 17b mit ungerader Zeilennummer um eine Spaltenbreite nach links verschoben. In der linken Randspalte sind nur die ungeradzahligen Matrixzeilen 17b, in der rechten Randspalte nur die geradzahligen Matrixzeilen 17a mit LEDs bestückt, so daß jede Matrixzeile dieselbe Anzahl von LEDs enthält.

Diese Gesamtanordnung der LEDs ermöglicht eine Verdrahtung der untereinander liegenden LEDs gleicher Farbe durch eine zickzackartige Serienschaltung und damit eine einfache Ansteuerung gleichfarbiger LEDs.

Gegenüber einer Anordnung, in der in den Matrixspalten nur gleichfarbige LEDs angeordnet sind, besitzt die gezeigte Anordnung den Vorteil, daß keine durchgehenden Linien oder Diagonalen gleicher Farbe auftreten. Damit wird eine homogen mischfarbige Abstrahlung erreicht und das Auftreten störender Artefakte unterdrückt.

Die Verdrahtung erfolgt in Richtung der Matrixspalten, wobei der Kontakt 12 auf dem Halbleiterkörper 11 einer jeden LED außer in der letzten Matrixzeile durch eine Drahtverbindung 13 mit der Aluminiumfläche 9 der diagonal darunterliegenden LED gleicher Farbe verbunden ist.

Die LEDs der ersten und letzten Matrixzeile sind mit Drahtverbindungen an weiter außen liegenden Kontaktfläche 18 angeschlossen. Im Betrieb werden über diese Kontaktflächen 18 jeweils die in zwei benachbarten Spalten angeordneten LEDs gleicher Farbe mit Strom versorgt.

Aufgrund der LED-Serienschaltung kann das Modul mit Spannungen versorgt werden, die einem Vielfachen der LED-Versorgungsspannungen entsprechen und die ohne großen Aufwand aus den üblichen mobilen Bordnetzen erzeugt werden können. Da die LED-Spalten gleicher Farbe voneinander getrennt angeschlossen werden können, ist auch bei einem Ausfall einer Spalte das Modul mit Vorteil noch weitgehend funktionstüchtig.

In Figur 2b ist eine Aluminiumfläche 9 vergrößert dargestellt. Diese Fläche 9 besitzt eine rechteckige Grundform, wobei an einer Ecke eine rechteckige Ausnehmung 19 gebildet ist und an einer der Ecke gegenüberliegenden Kante ein der Ausnehmung 19 entsprechendes, etwas verkleinertes Flächenstück 20 angesetzt ist.

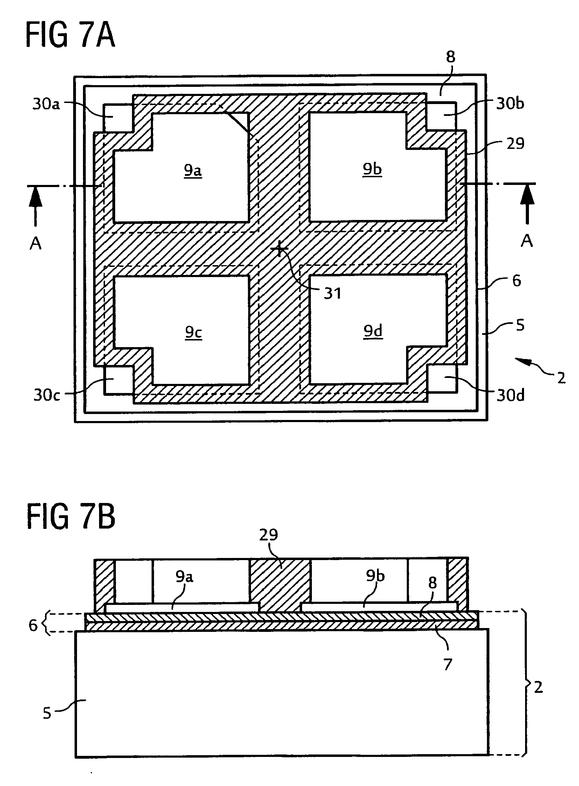

Diese Formgebung ermöglicht eine flächenfüllende und voneinander isolierte Anordnung der Aluminiumflächen 9. Das Flächenstück 20 bildet dabei den Drahtanschlußbereich zur Kontaktierung des jeweils auf der Alumiumfläche 9 aufgebrachten Halbleiterkörpers 11. Dieser Drahtanschlußbereich ist von dem Chipanschlußbereich 10 beabstandet, da sich bei der Montage des Halbleiterkörpers 11 auf den Chipanschlußbereich 10 Lot- bzw. Klebstoffreste in der Umgebung des Chipanschlußbereichs 10 ablagern können, die eine sichere Drahtkontaktierung erschweren. Die in Figur 7 abgebildete Struktur löst dieses Problem.

Die in den geradzahligen Matrixzeilen 17a angeordneten Flächen 9 entsprechen der in Figur 2b gezeigten Form. Die Flächen 9 in den ungeradzahligen Matrixzeilen 17b gehen aus dieser Form durch horizontale Spiegelung hervor. Die abwechselnde Anordnung dieser Formen ermöglicht die gezeigte Serienschaltung mit Zickzackverdrahtung bei vorteilhaft kurzen Verdrahtungswegen.

Das so gebildete LED-Modul weist eine Kantenlänge von etwa 9mm x 10mm auf und erreicht für Weißlicht eine Leuchtdichte von 77 kcd/m². Damit stellt das LED-Modul eine Lichtquelle mit einstellbarer Farbe, insbesondere eine Weißlichtquelle auf LED-Basis mit höchster Packungs- und Leuchtdichte dar.

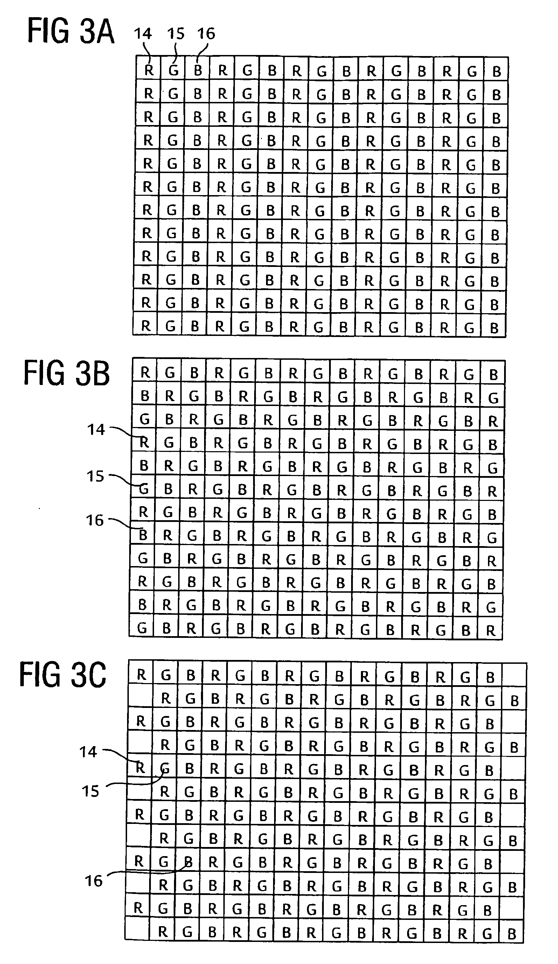

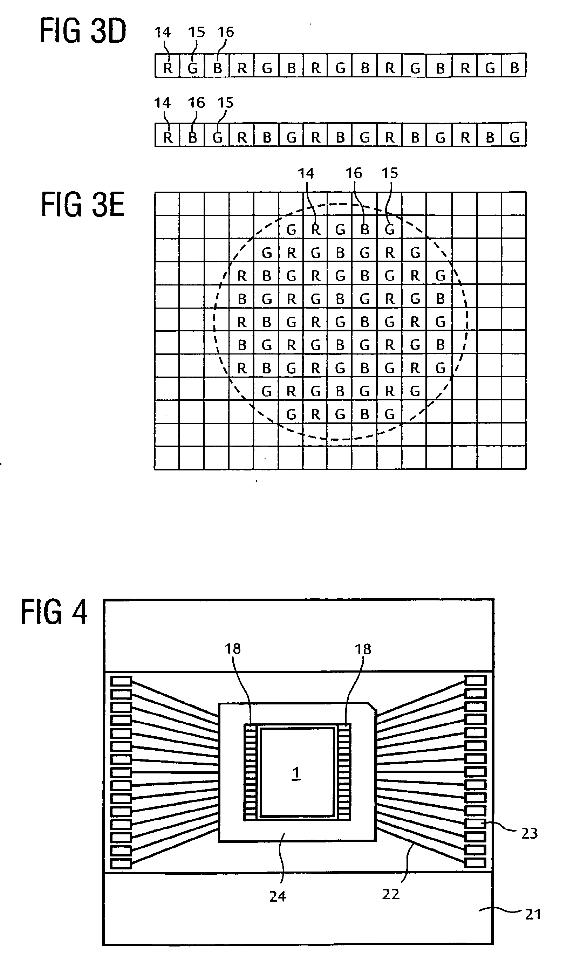

In Figur 3 sind weitere vorteilhafte Anordnungen hinsichtlich der LED-Farbe gezeigt. Bei dem in Figur 3a dargestellten Beispiel sind die LEDs in den Matrixzeilen wiederum in periodisch wiederkehrender Folge angeordnet. In den Matrixspalten sind jeweils LEDs gleicher Farbe angeordnet. Die Serienschaltung von LEDs gleicher Farbe ist hierbei besonders einfach.

Bei dem in Figur 3b dargestellten Beispiel sind die LEDs in den Matrixzeilen ebenfalls in periodisch wiederkehrender Folge angeordnet. Die Anordnung in einer Matrixzeile ergibt sich dabei ab der zweiten Zeile aus der darüberliegenden Matrixzeile durch Verschiebung um eine Spaltenbreite nach rechts. Auch hier können die LEDs gleicher Farbe durch Serienschaltungen entlang der Diagonalen von links oben nach rechts unten leicht zusammengefaßt werden.

Das in Figur 3c dargestellt Beispiel entspricht der in Figur 2a gezeigten Anordnung. Hierbei wurden durchgehende Linien gleicher Farbe vermieden, so daß keine störenden Artefakte entstehen können und so eine besonders homogen abstrahlende Lichtquelle gebildet ist.

Selbstverständlich können beide zyklische Dreierpermutationen der LED-Farben, die in Figur 3d dargestellt sind, verwendet werden. Ebenso können alle Matrixzeilen gegen die entsprechenden Spalten vertauscht werden.

Bei der in Figur 3e dargestellten Anordnung sind nur die innerhalb eines kreisförmigen Umrisses (gestrichelt) liegenden Rasterplätze bestückt. Diese Anordnung ist vorteilhaft in Verbindung mit einer Optik mit einer entsprechenden kreisförmiger Eintrittsapertur, wie sie beispielsweise zylindersymmetrische Optiken aufweisen. Durch die gezeigte Anordnung wird die Eintrittsapertur gleichmäßig ausgeleuchtet. Zugleich wird durch die Reduktion der LED-Bestückung auf Rasterplätze, die innerhalb der Eintrittsapertur liegen, die Leistungsaufnahme des LED-Moduls vorteilhaft gesenkt, ohne damit die Ausleuchtung der Optik zu verringern.

Hinsichtlich ihrer Farben sind die LEDs bei diesem Beispiel ähnlich wie in Figur 3c angeordnet, so daß LEDs gleicher Farbe durch zickzackartige Serienschaltung in Richtung der Matrixspalten zusammengefaßt werden können. Hingegen wurde von der periodisch wiederkehrenden Anordnung entlang der Matrixzeilen abgewichen und die Anzahl der grünen LEDs erhöht, so daß bei diesem Modul insgesamt 34 grüne, 19 rote und 16 blaue LEDs verwendet werden. Bei dieser Gewichtung der LED-Anzahl erzeugt das LED-Modul bei gleicher Bestromung aller LEDs weißes Mischlicht.

Je nach Anwendungsfall können auch einzelne Aspekte der in den Figuren 3a bis 3e dargestellten Anordungen kombiniert werden. Selbstverständlich können auch einfachere Schaltungen und Anordnungen, beispielsweise eine ungeordnete Verteilung der LED-Farben oder eine reine Serienschaltung aller LEDs verwendet werden. Im letzteren Fall hängt wie bei Figur 3e der Farbort des Mischlichts von den Häufigkeiten der LEDs gleicher Farbe ab.

In Figur 4 ist ein Beispiel des LED-moduls in vormontiertem Zustand gezeigt. Das LED-Modul 1 ist auf das Zentrum einer Grundplatte 21 aus Kupfer geklebt oder gelötet. Die Kontaktanschlüsse 18 zur Stromversorgung der LED-Matrixspalten sind über einen Leiterrahmen 22 mit strahlenförmig nach außen verlaufenden Leiterbahnen zu vergrößerten Lötanschlüssen 23 am Rand der Grundplatte geführt, wobei die Lötanschlüsse 23 so beabstandet und ausgeführt sind, daß sie leicht mit einer elektronischen Baugruppe zur Ansteuerung bzw. Stromversorgung des LED-Moduls 1 verbunden werden können.

Über dem Leiterrahmen ist ein Vergußrahmen 24 montiert, dessen Innenbereich mit einer dünnen Vergußschicht, vorzugsweise aus einem transparenten Reaktionsharz wie zum Beispiel Epoxidharz, zum Schutz des LED-Moduls gefüllt ist.

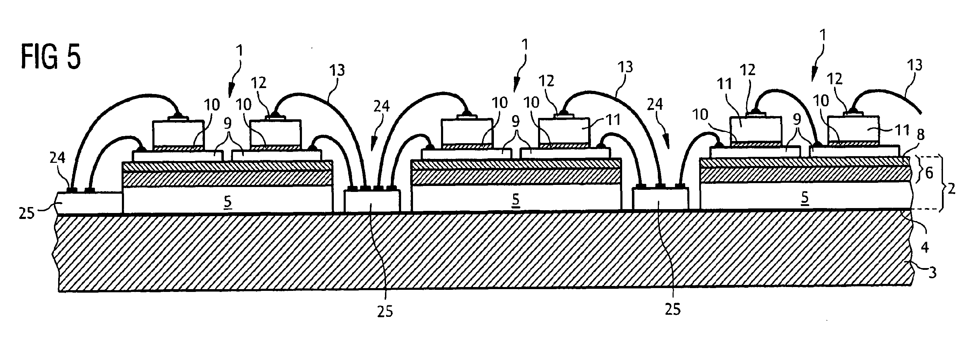

In Figur 5 ist ein weiteres Beispiel dargestellt. Im Unterschied zu dem in Figur 1 dargestellten Beispiel ist hier eine Mehrzahl von LED-Modulen 1 auf einen gemeinsamen Kühlkörper 3 montiert, so daß eine Mehrfachanordnung von LED-Modulen 1 gebildet wird.

Der Aufbau der einzelnen LED-Module 1, umfassend einen Träger 2 mit einer Halbleiterschicht 5 und einer mehrlagigen Isolierschicht 6, auf dem Träger ausgebildete Metallflächen 9 mit Chipanschlußbereichen 10 sowie darauf befestigte LED-Halbleiterkörper 11, entspricht im wesentlichen dem in Figur 1 gezeigten LED-Modul.

Die Anzahl der LEDs auf den einzelnen LED-Modulen kann dabei den individuellen Bedürfnissen angepaßt werden. Beispielsweise kann jedes LED-Modul eine rote LED, zwei grüne LEDs und eine blaue LED, also insgesamt vier LEDs enthalten. Bei entsprechend abgestimmen Betriebsströmen der LEDs bildet jedes LED-Modul für sich eine Weißlichtquelle. Es versteht sich, daß sich die LED-Module auch als Farblichtquellen, insbesondere für mischfarbiges Licht eignen, wobei vorteilhafterweise die LED-Module in allen Fällen eine hohe Packungsdichte aufweisen und daher nahezu punktförmig sind.

Zur elektischen Versorgung der einzelnen LED-Module sind zwischen den LED-Modulen 1 Leiterbahnen 24 angeordnet. Über Drahtverbindungen 13 wird der Betriebsstrom in die einzelnen LEDs eingeprägt. Durch diese direkte Stromzuführung können die einzelnen LED-Module und weitergehend die einzelnen LEDs unabhängig voneinander angesteuert und geschaltet werden. Dies schließt selbstverständlich eine Serien- und/oder Parallelschaltung einzelner Module oder LEDs nicht aus, falls eine unabhängige Steuerung nicht gewünscht wird.

Die Leiterbahnen 24 sind vorzugsweise auf einem geeigneten Leiterbahnenträger 25, beispielsweise eine Leiterplatte, ausgebildet. Bevorzugt wird hierfür eine flexible Leiterplatte oder eine entsprechende Leiterplattenfolie, beispielsweise ein Flexboard, verwendet.

Die einzelnen LED-Module 1 sind bevorzugt zweidimensional und matrixartig auf dem Kühlkörper angeordnet. So können beispielsweise 32 LED-Module mit je vier LED-Chips auf einem gemeinsamen Kühlkörper zusammengefaßt sein. Der Leiterbahnenträger 25 mit den darauf aufgebrachten Leiterbahnen 24 ist hierbei zweckmäßigerweise Form eines Gitters ausgebildet, wobei in den Gitteröffnungen die LED-Module 1 angeordnet sind.

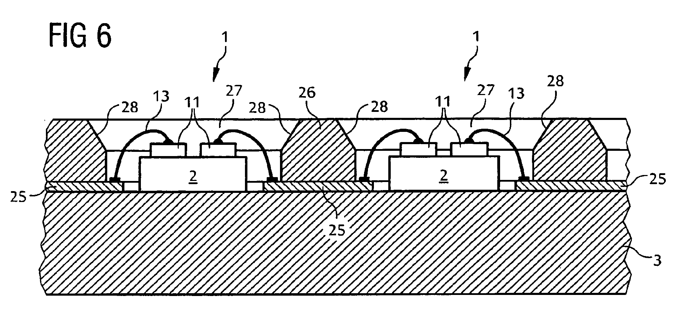

In Figur 6 ist ein weiteres Beispiel dargestellt. Wie bei dem in Figur 5 gezeigten Beispiel sind auf einem Kühlkörper 3 mehrere LED-Module 1 mit dazwischen angeordneten Leiterbahnen 24 montiert. Dargestellt sind bei den LED-Modulen 1 jeweils nur der Träger 2 und die LEDs 11. Im einzelnen kann ein Aufbau wie bei den bisher beschriebenen LED-Modulen verwendet werden. Auf diese Anordnung ist im Unterschied zu dem in Figur 5 gezeigten Beispiel ein Reflektor 26 aufgesetzt, der zum Beispiel auf der von dem Kühlkörper 3 abgewandten Seite der Leiterbahnträger 25 aufliegen kann.

Der Reflektor weist eine Mehrzahl von Durchbrüchen auf 27, deren Seitenflächen 28 zumindest teilweise angeschrägt sind und als Reflexionsflächen dienen. In der Aufsicht weist der Reflektor eine dem Leiterbahnträger 25 entsprechende, zum Beispiel gitterartige, Form auf. Durch den Reflektor wird die Lichtausbeute der LED-Module vorteilhaft erhöht.

In Figur 7a ist eine Aufsicht auf einen Träger 2 für ein LED-Modul mit vier LEDs dargestellt. Derartige erfindungsgemäße LED-Module können beispielsweise bei den in Figur 5 und 6 gezeigten Beispielen verwendet werden. Figur 7b zeigt eine zugehörige Ansicht eines Schnitts entlang der Linie A-A. Der Übersichtlichkeit halber sind insbesondere die Schichtdicken nicht maßstabsgetreu dargestellt.

Der Träger umfaßt wie bereits beschrieben eine Halbleiterschicht 5, vorzugsweise Silizium oder Galliumarsenid enthaltend, sowie eine Isolierschicht 6, die wiederum eine Siliziumoxidschicht 7 und eine Siliziumnitridschicht 8 aufweisen kann.

Auf der Isolierschicht 6 sind vier voneinander beabstandete und elektrisch isolierte Metallflächen 9a, 9b, 9c und 9d, beispielsweise aus Aluminium angeordnet, die von einer rahmenartigen Struktur 29 eingefaßt werden. Auf den Metallflächen können wie bereits beschrieben Chipanschlußbereiche zur Montage der LEDs ausgebildet werden (nicht dargestellt).

Die rahmenartige Struktur 29 ist erhaben, beispielsweise mit einer Dicke bis 30 µm, insbesondere zwischen 5 µm und 25 µm, ausgebildet und dient als Auffangreservoir für Haftmittel wie Silberleitkleber, die zur Montage der LEDs verwendet werden. Die rahmenartige Struktur 29 bildet dabei um jede Metallfläche bzw. jeden Chipanschlußbereich herum ein wannenförmiges Reservoir, das ein Übertreten überschüssigen Haftmittels zur benachbarten Metallfläche und damit die Entstehung eines Kurzschlusses zwischen den einzelnen LEDs verhindert.

Derartige rahmenartige Strukturen können zum Beispiel aus einem Kunststoff, vorzugsweise Polyimid, hergestellt werden, indem eine entsprechende Kunststoffschicht mittels halbleitertechnischer Prozesse aufgebracht und strukturiert wird.

Von den Ecken des Trägers ist die rahmenartige Struktur 29 weiter beabstandet und zur Trägermitte 31 hin zurückgezogen ausgebildet, so daß von der Trägermitte 31 aus gesehen außerhalb der rahmenartigen Struktur 29 Teilbereiche 30a, 30b 30c und 30d der Metallschichten 9a, 9b, 9c und 9d unbedeckt sind. Diese Teilbereiche 30a, 30b 30c und 30d dienen als Anschlußstellen für externe Drahtverbindungen, beispielsweise zu den in Figur 5 und 6 gezeigten Leiterbahnen, wobei jeder Teilbereich mit der zugehörigen Metallfläche elektrisch leitend verbunden ist.

Die Erläuterung der Erfindung anhand des beschriebenen Ausführungsbeispiels ist selbstverständlich nicht als Beschränkung der Erfindung zu verstehen.

## Patentansprüche

1. LED-Modul (1) mit einer Mehrzahl von LED-Halbleiterkörpern (11) und einem Träger (2) mit einer ersten und einer zweiten Hauptfläche, wobei
- die erste Hauptfläche des Trägers (2) eben ausgebildet ist und auf der ersten Hauptfläche des Trägers (2) leitfähige Bereiche (9) ausgebildet sind, auf die die LED-Halbleiterkörper (11) aufgebracht sind,
- die LED-Halbleiterkörper (11) mittels eines Haftmittels aufgelötet oder aufgeklebt sind,
- der Träger (2) mindestens eine Halbleiterschicht (5) aufweist,
**dadurch gekennzeichnet, daß** zumindest teilweise um die LED-Halbleiterkörper herum ein Reservoir für das Haftmittel ausgebildet ist, welches als Auffangreservoir für das Haftmittel dient und ein Übertreten überschüssigen Haftmittels zu benachbarten leitfähigen Bereichen verhindert.

2. LED-Modul (1) nach Anspruch 1,
**dadurch gekennzeichnet, daß** die mindestens eine Halbleiterschicht (5) Silizium oder Galliumarsenid enthält.

3. LED-Modul (1) nach Anspruch 1 oder 2,
**dadurch gekennzeichnet, daß** der Träger mehrlagig gebildet ist.

4. LED-Modul (1) nach einem der Ansprüche 1 bis 3,
**dadurch gekennzeichnet, daß** der Träger (2) auf der Seite der ersten Hauptfläche von mindestens einer elektrischen Isolierschicht (6) begrenzt ist.

5. LED-Modul (1) nach Anspruch 4,
**dadurch gekennzeichnet, daß** die mindestens eine Isolierschicht (6) mehrlagig gebildet ist.

6. LED-Modul (1) nach Anspruch 4 oder 5,
**dadurch gekennzeichnet, daß** die mindestens eine Isolierschicht (6) Siliziumoxid oder Siliziumnitrid enthält.

7. LED-Modul (1) nach einem der Ansprüche 4 bis 6,
**dadurch gekennzeichnet, daß** die Isolierschicht (6) eine Siliziumoxidschicht und eine Siliziumnitridschicht aufweist, wobei die Siliziumoxidschicht an den Träger (2) angrenzt.

8. LED-Modul (1) nach einem der Ansprüche 1 bis 7,
**dadurch gekennzeichnet, daß** die leitfähigen Bereiche (9) ein hohes Reflexionsvermögen im Spektralbereich der von den LED-Halbleiterkörpern (11) emittierten Strahlung aufweisen.

9. LED-Modul (1) nach einem der Ansprüche 1 bis 8,
**dadurch gekennzeichnet, daß** die leitfähigen Bereiche (9) Aluminium enthalten.

10. LED-Modul (1) nach einem der Ansprüche 4 bis 7,
**dadurch gekennzeichnet, daß** die leitfähigen Bereiche (9) auf der Isolierschicht (6) angeordnet sind.

11. LED-Modul (1) nach einem der Ansprüche 1 bis 9,
**dadurch gekennzeichnet, daß** auf den leitfähigen Bereichen (9) Chipanschlußbereiche (10) gebildet sind und die LED-Halbleiterkörper (11) auf den Chipanschlußbereichen (10) aufgebracht sind.

12. LED-Modul (1) nach Anspruch 11,
**dadurch gekennzeichnet, daß** die Chipanschlußbereiche (10) jeweils einen Stapel dünner Metallschichten aufweisen.

13. LED-Modul (1) nach Anspruch 12,
**dadurch gekennzeichnet, daß**
die Metallschichten Titan, Kupfer oder Edelmetalle, insbesondere Gold oder Platin, enthalten.

14. LED-Modul (1) nach einem der Ansprüche 1 bis 13,
**dadurch gekennzeichnet, daß**
der Träger (2) auf der Seite der zweiten Hauptfläche mit einem Kühlkörper (3) verbunden ist.

15. LED-Modul (1) nach Anspruch 14,
**dadurch gekennzeichnet, daß**
der Kühlkörper (3) Kupfer oder Aluminium enthält.

16. LED-Modul (1) nach Anspruch 14 oder 15,
**dadurch gekennzeichnet, daß**
der Kühlkörper (3) an die Halbleiterschicht (5) grenzt.

17. LED-Modul (1) nach Anspruch 16,
**dadurch gekennzeichnet, daß**
der Kühlkörper (3) mit der Halbleiterschicht (5) durch eine Lötmasse (4) oder einen wärmeleitfähigen Klebstoff verbunden ist.

18. LED-Modul (1) nach einem der Ansprüche 1 bis 17,
**dadurch gekennzeichnet, daß**
die LED-Halbleiterkörper (11) auf dem Träger (2) in Form einer Matrix angeordnet sind.

19. LED-Modul (1) nach einem der Ansprüche 1 bis 18,
**dadurch gekennzeichnet, daß**
die LED-Halbleiterkörper (11) im Betrieb Licht verschiedener Zentralwellenlänge emittieren.

20. LED-Modul (1) nach Anspruch 19,
**dadurch gekennzeichnet, daß**
das von den einzelnen LED-Halbleiterkörpern (11) im Betrieb emittierte Licht Zentralwellenlängen im roten, grünen oder blauen Spektralbereich aufweist.

21. LED-Modul (1) nach Anspruch 19 oder 20,
**dadurch gekennzeichnet, daß**
die LED-Halbleiterkörper (11) mit der jeweils gleichen Zentralwellenlänge regelmäßig auf dem Träger (2) angeordnet sind.

22. LED-Modul (1) nach Anspruch 21,
**dadurch gekennzeichnet, daß**
die LED-Halbleiterkörper (11) in den Matrixzeilen (17a,b) bezüglich ihrer Zentralwellenlängen in periodisch wiederkehrender Folge angeordnet sind.

23. LED-Modul (1) nach Anspruch 21 oder 22,
**dadurch gekennzeichnet, daß**
die Anordnung der LED-Halbleiterkörper (11) in den Matrixzeilen (17a,b) bezüglich der Zentralwellenlängen dieselbe periodisch wiederkehrende Folge aufweist.

24. LED-Modul (1) nach Anspruch 23,
**dadurch gekennzeichnet, daß**
in den Matrixspalten jeweils LED-Halbleiterkörper (11) mit derselben Zentralwellenlänge angeordnet sind.

25. LED-Modul (1) nach Anspruch 23,
**dadurch gekennzeichnet, daß**
die Anordnung der LED-Halbleiterkörper (11) in den Matrixzeilen (17b) mit ungerader Zeilennummer gleich ist und die Anordnung in den Matrixzeilen (17a) mit gerader Zeilennummer aus der darüber liegenden Matrixzeile (17b) durch Verschiebung um eine Spaltenbreite nach links oder nach rechts her vorgeht.

26. LED-Modul nach einem der Ansprüche 1 bis 25,
**dadurch gekennzeichnet, daß**
das Haftmittel elektrisch leitfähig ist.

27. LED-Modul nach einem der Ansprüche 1 bis 26,
**dadurch gekennzeichnet, daß**
das Haftmittel ein Lot oder ein Klebstoff, insbesondere ein Silberleitklebstoff, ist.

28. Mehrfachanordnung mit einer Mehrzahl von LED-Modulen (1) nach einem der Ansprüche 1 bis 27,
**dadurch gekennzeichnet, daß**
die LED-Module (1) auf einen gemeinsamen Kühlkörper (3) aufgebracht sind, wobei jeweils der Träger (2) der LED-Module (1) auf der Seite der zweiten Hauptfläche mit dem Kühlkörper (3) verbunden ist.

29. Mehrfachanordnung nach Anspruch 28,
**dadurch gekennzeichnet, daß**
der Kühlkörper (3) Kupfer oder Aluminium enthält.

30. Mehrfachanordnung nach Anspruch 28 oder 29,
**dadurch gekennzeichnet, daß**
jeweils die Halbleiterschicht (5) der LED-Module (1) an den Kühlkörper (3) grenzt.

31. Mehrfachanordnung nach Anspruch 30,
**dadurch gekennzeichnet, daß**
jeweils die Halbleiterschicht (5) der LED-Module (1) mit dem Kühlkörper (3) durch eine Lötmasse (4) oder einen wärmeleitfähigen Klebstoff verbunden ist.

32. Mehrfachanordnung nach einem der Ansprüche 28 bis 31,
**dadurch gekennzeichnet, daß**
zwischen den LED-Modulen Leiterbahnen angeordnet sind.

33. Mehrfachanordnung nach Anspruch 32,
**dadurch gekennzeichnet, daß**
die Leiterbahnen auf einem Leiterbahnträger ausgebildet sind, der insbesondere auf dem Kühlkörper aufliegt.

34. Mehrfachanordnung nach Anspruch 33,
**dadurch gekennzeichnet, daß**
der Leiterbahnträger eine Leiterplatte, eine flexible Leiterplatte, eine Leiterplattenfolie oder ein Flexboard ist.

35. Verwendung eines LED-Moduls (1) nach einem der Ansprüche 1 bis 27 oder einer Mehrfachanordnung nach einem der Ansprüche 28 bis 34 zur Erzeugung weißen Mischlichts,
**dadurch gekennzeichnet, daß**
der Farbort des Mischlichts durch den Betriebsstrom der LED-Halbleiterkörper (11) festgelegt wird.

36. Verwendung nach Anspruch 35,
**dadurch gekennzeichnet, daß**
LED-Halbleiterkörper (11) mit gleicher Zentralwellenlänge mit dem gleichen Betriebsstrom versorgt werden.

37. Verwendung eines LED-Moduls (1) nach einem der Ansprüche 19 bis 27 oder einer Mehrfachanordnung nach einem der Ansprüche 28 bis 34 zur Erzeugung weißen Mischlichts,
**dadurch gekennzeichnet, daß**
die Häufigkeiten der LED-Halbleiterkörper (11) mit gleicher Zentralwellenlänge so gewählt sind, daß bei gleicher Bestromung aller LED-Halbleiterkörper (11) weißes Mischlicht erzeugt wird.

## Claims

1. LED module (1) having a plurality of LED semiconductor bodies (11) and a carrier (2) having a first and a second main area, wherein
- the first main area of the carrier (2) is of planar design and conductive regions (9), to which the LED semiconductor bodies (11) are applied, are formed on the first main area of the carrier (2),
- the LED semiconductor bodies (11) are soldered on or adhesively bonded on by means of an adhesion agent,
- the carrier (2) has at least one semiconductor layer (5),
**characterized in that**
a reservoir for the adhesion agent is formed at least partially around the LED semiconductor bodies, which reservoir serves as a collecting reservoir for the adhesion agent and prevents excess adhesion agent from spilling over to adjacent conductive regions.

2. LED module (1) according to Claim 1,
**characterized in that**
the at least one semiconductor layer (5) contains silicon or gallium arsenide.

3. LED module (1) according to Claim 1 or 2,
**characterized in that**
the carrier is formed in multilayer fashion.

4. LED module (1) according to one of Claims 1 to 3,
**characterized in that**
the carrier (2) is bounded by at least one electrical insulating layer (6) on the side of the first main area.

5. LED module (1) according to Claim 4,
**characterized in that**
the at least one insulating layer (6) is formed in multilayer fashion.

6. LED module (1) according to Claim 4 or 5,
**characterized in that**
the at least one insulating layer (6) contains silicon oxide or silicon nitride.

7. LED module (1) according to one of Claims 4 to 6,
**characterized in that**
the insulating layer (6) has a silicon oxide layer and a silicon nitride layer, the silicon oxide layer adjoining the carrier (2).

8. LED module (1) according to one of Claims 1 to 7,
**characterized in that**
the conductive regions (9) have a high reflectivity in the spectral region of the radiation emitted by the LED semiconductor bodies (11).

9. LED module (1) according to one of Claims 1 to 8,
**characterized in that**
the conductive regions (9) contain aluminum.

10. LED module (1) according to one of Claims 4 to 7,
**characterized in that**
the conductive regions (9) are arranged on the insulating layer (6).

11. LED module (1) according to one of Claims 1 to 9,
**characterized in that**
chip connection regions (10) are formed on the conductive regions (9) and the LED semiconductor bodies (11) are applied on the chip connection regions (10).

12. LED module (1) according to Claim 11,
**characterized in that**
the chip connection regions (10) each have a stack of thin metal layers.

13. LED module (1) according to Claim 12,
**characterized in that**
the metal layers contain titanium, copper or noble metals, in particular gold or platinum.

14. LED module (1) according to one of Claims 1 to 13,
**characterized in that**
the carrier (2) is connected to a heat sink (3) on the side of the second main area.

15. LED module (1) according to Claim 14,
**characterized in that**
the heat sink (3) contains copper or aluminum.

16. The LED module (1) according to claim 14 or 15,
**characterized in that**
the heat sink (3) adjoins the semiconductor layer (5).

17. LED module (1) according to Claim 16,
**characterized in that**
the heat sink (3) is connected to the semiconductor layer (5) by a soldering compound (4) or a thermally conductive adhesive.

18. LED module (1) according to one of Claims 1 to 17,
**characterized in that**
the LED semiconductor bodies (11) are arranged on the carrier (2) in the form of a matrix.

19. LED module (1) according to one of Claims 1 to 18,
**characterized in that**
the LED semiconductor bodies (11) emit light of differing central wavelength during operation.

20. LED module (1) according to Claim 19,
**characterized in that**
the light emitted by the individual LED semiconductor bodies (11) during operation has central wavelengths in the red, green or blue spectral region.

21. LED module (1) according to Claim 19 or 20,
**characterized in that**
the LED semiconductor bodies (11) with the same central wavelength in each case are arranged regularly on the carrier (2).

22. LED module (1) according to Claim 21,
**characterized in that**
the LED semiconductor bodies (11) are arranged in a periodically recurring sequence with regard to their central wavelengths in the matrix rows (17a, b).

23. LED module (1) according to Claim 21 or 22,
**characterized in that**
the arrangement of the LED semiconductor bodies (11) in the matrix rows (17a, b) has the same periodically recurring sequence with regard to the central wavelengths.

24. LED module (1) according to Claim 23,
**characterized in that**
LED semiconductor bodies (11) with the same central wavelength are in each arranged in the matrix columns.

25. LED module (1) according to Claim 23,
**characterized in that**
the arrangement of the LED semiconductor bodies (11) in the matrix rows (17b) with an odd row number is identical and the arrangement in the matrix rows (17a) with an even row number emerges from the overlying matrix row (17b) by displacement by one column width toward the left or toward the right.

26. LED module according to one of Claims 1 to 25,
**characterized in that**
the adhesion agent is electrically conductive.

27. LED module according to one of Claims 1 to 26,
**characterized in that**
the adhesion agent is a solder or an adhesive, in particular a silver conductive adhesive.

28. Multiple arrangement having a plurality of LED modules (1) according to one of Claims 1 to 27,
**characterized in that**
the LED modules (1) are applied to a common heat sink (3), the carrier (2) of the LED modules (1) in each case being connected to the heat sink (3) on the side of the second main area.

29. Multiple arrangement according to Claim 28,
**characterized in that**
the heat sink (3) contains copper or aluminum.

30. Multiple arrangement according to Claim 28 or 29,
**characterized in that**
the semiconductor layer (5) of the LED modules (1) in each case adjoins the heat sink (3).

31. Multiple arrangement according to Claim 30,
**characterized in that**
the semiconductor layer (5) of the LED modules (1) is in each case connected to the heat sink (3) by a soldering compound (4) or a thermally conductive adhesive.

32. Multiple arrangement according to one of Claims 28 to 31,
**characterized in that**
conductor tracks are arranged between the LED modules.

33. Multiple arrangement according to Claim 32,
**characterized in that**
the conductor tracks are formed on a conductor track carrier which bears, in particular, on the heat sink.

34. Multiple arrangement according to Claim 33,
**characterized in that**
the conductor track carrier is a printed circuit board,
a flexible printed circuit board, a printed circuit board sheet or a flexboard.

35. Use of an LED module (1) according to one of Claims 1 to 27 or of a multiple arrangement according to one of Claims 28 to 34 for generating white mixed light,
**characterized in that**
the color locus of the mixed light is defined by the operating current of the LED semiconductor bodies (11).

36. Use according to Claim 35,
**characterized in that**
LED semiconductor bodies (11) with the same central wavelength are supplied with the same operating current.

37. Use of an LED module (1) according to one of Claims 19 to 27 or of a multiple arrangement according to one of Claims 28 to 34 for generating white mixed light,
**characterized in that**
the frequencies of the LED semiconductor bodies (11) with the same central wavelength are chosen such that white mixed light is generated when all the LED semiconductor bodies (11) are energized identically.

## Revendications

1. Module (1) de LED présentant plusieurs corps semi-conducteurs (11) de LED et un support (2) qui présente une première et une deuxième surface principale,
la première surface principale du support (2) étant plane et des parties conductrices (9) sur lesquelles les corps semi-conducteurs (11) de LED sont placés étant formées sur la première surface principale du support (2),
les corps semi-conducteurs (11) de LED étant brasés ou collés à l'aide d'un agent adhésif,
le support (2) présentant au moins une couche semi-conductrice (5),
**caractérisé en ce que**
un réservoir d'agent adhésif qui sert de réservoir de reprise de l'agent adhésif et empêche le débordement d'agent adhésif en excès vers des parties conductrices voisines est formé au moins en partie autour des corps semi-conducteurs de LED.

2. Module (1) de LED selon la revendication 1, **caractérisé en ce que** la ou les couches semiconductrices (5) contiennent du silicium ou de l'arsénure de gallium.

3. Module (1) de LED selon les revendications 1 ou 2, **caractérisé en ce que** le support est en plusieurs couches.

4. Module (1) de LED selon l'une des revendications 1 à 3, **caractérisé en ce que** le support (2) est délimité par au moins une couche électriquement isolante (6) sur le côté de la première surface principale.

5. Module (1) de LED selon la revendication 4, **caractérisé en ce que** la ou les couches isolantes (6) est en plusieurs couches.

6. Module (1) de LED selon les revendications 4 ou 5, **caractérisé en ce que** la ou les couches isolantes (6) contient de l'oxyde de silicium ou du nitrure de silicium.

7. Module (1) de LED selon l'une des revendications 4 à 6, **caractérisé en ce que** la couche isolante (6) présente une couche d'oxyde de silicium et une couche de nitrure de silicium, la couche d'oxyde de silicium étant adjacente au support (2).

8. Module (1) de LED selon l'une des revendications 1 à 7, **caractérisé en ce que** les parties conductrices (9) présentent une capacité de réflexion élevée dans la plage spectrale du rayonnement émis par les corps semi-conducteurs (11) de LED.

9. Module (1) de LED selon l'une des revendications 1 à 8, **caractérisé en ce que** les parties conductrices (9) contiennent de l'aluminium.

10. Module (1) de LED selon l'une des revendications 4 à 7, **caractérisé en ce que** les parties conductrices (9) sont disposées sur la couche isolante (6).

11. Module (1) de LED selon l'une des revendications 1 à 9, **caractérisé en ce que** des parties (10) de raccordement de puce sont formées sur les parties conductrices (9) et **en ce que** les corps semi-conducteurs (11) de LED sont placés sur les parties (10) de raccordement de puce.

12. Module (1) de LED selon la revendication 11, **caractérisé en ce que** les parties (10) de raccordement de puce présentent chacune une pile de minces couches de métal.

13. Module (1) de LED selon la revendication 12, **caractérisé en ce que** les couches de métal contiennent du titane, du cuivre ou des métaux précieux, en particulier l'or ou le platine.

14. Module (1) de LED selon l'une des revendications 1 à 13, **caractérisé en ce que** le support (2) est raccordé à un corps de refroidissement (3) sur le côté de la deuxième surface principale.

15. Module (1) de LED selon la revendication 14, **caractérisé en ce que** le corps de refroidissement (3) contient du cuivre ou de l'aluminium.

16. Module (1) de LED selon les revendications 14 ou 15, **caractérisé en ce que** le corps de refroidissement (3) est adjacent à la couche semi-conductrice (5).

17. Module (1) de LED selon la revendication 16, **caractérisé en ce que** le corps de refroidissement (3) est relié à la couche semi-conductrice (5) par une pâte de brasage (4) ou par un adhésif thermiquement conducteur.

18. Module (1) de LED selon l'une des revendications 1 à 17, **caractérisé en ce que** les corps semi-conducteurs (11) de LED sont disposés sur le support (2) en forme de matrice.

19. Module (1) de LED selon l'une des revendications 1 à 18, **caractérisé en ce que** les corps semi-conducteurs (11) de LED émettent en fonctionnement de la lumière de différentes longueurs d'onde central.

20. Module (1) de LED selon la revendication 19, **caractérisé en ce que** la lumière émise par les différents corps semi-conducteurs (11) de LED en fonctionnement présente des longueurs d'onde centrale dans la plage spectrale du rouge, du vert ou du bleu.

21. Module (1) de LED selon les revendications 19 ou 20, **caractérisé en ce que** les différents corps semi-conducteurs (11) qui présente la même longueur d'onde centrale sont disposés régulièrement sur le support (2).

22. Module (1) de LED selon la revendication 21, **caractérisé en ce que** les corps semi-conducteurs (11) de LED des lignes (17a, b) de la matrice sont disposés en succession périodiquement répétée en termes de leur longueur d'onde centrale.

23. Module (1) de LED selon les revendications 21 ou 22, **caractérisé en ce que** l'agencement des corps semi-conducteurs (11) de LED dans les cellules de matrice (17a, b) présente une succession périodiquement répétée en termes de leur longueur d'onde centrale.

24. Module (1) de LED selon la revendication 23, **caractérisé en ce que** dans les colonnes de la matrice, des corps semi-conducteurs (11) de LED de même longueur d'onde centrale sont disposés.

25. Module (1) de LED selon la revendication 23, **caractérisé en ce que** l'agencement des corps semi-conducteurs (11) de LED dans les lignes (17b) de la matrice de numéro impair est identique et l'agencement dans les lignes de matrice (17a) de numéro pair à partir de la ligne de matrice (17b) située par dessus avance vers la gauche ou vers la droite par décalage d'une largeur de colonne.

26. Module de LED selon l'une des revendications 1 à 25, **caractérisé en ce que** l'agent adhésif est électriquement conducteur.

27. Module de LED selon l'une des revendications 1 à 26, **caractérisé en ce que** l'agent adhésif est une brasure ou un adhésif, en particulier un adhésif conducteur à l'argent.

28. Ensemble multiple présentant plusieurs modules (1) de LED selon l'une des revendications 1 à 27, **caractérisé en ce que** les modules (1) de LED sont placés sur un corps de refroidissement (3) commun, le support (2) des modules (1) de LED étant raccordé au corps de refroidissement (3) sur le côté de la deuxième surface principale.

29. Ensemble multiple selon la revendication 28, **caractérisé en ce que** le corps de refroidissement (3) contient du cuivre ou de l'aluminium.

30. Ensemble multiple selon les revendications 28 ou 29, **caractérisé en ce que** la couche semi-conductrice (5) des modules (1) de LED est adjacente au corps de refroidissement (3).

31. Ensemble multiple selon la revendication 30, **caractérisé en ce que** la couche semi-conductrice (5) des modules (1) de LED est raccordée au corps de refroidissement (3) par une pâte de brasure (4) ou par un adhésif conducteur de la chaleur.

32. Ensemble multiple selon l'une des revendications 28 à 31, **caractérisé en ce que** des pistes conductrices sont disposées entre le module de LED.

33. Ensemble multiple selon la revendication 32, **caractérisé en ce que** les pistes conductrices sont formées d'un support de piste conductrice qui repose en particulier sur le corps de refroidissement.

34. Ensemble multiple selon la revendication 33, **caractérisé en ce que** le support de piste conductrice est une carte de circuit, une carte de circuit flexible, une feuille de carte de circuit ou une feuille flexible.

35. Utilisation d'un module (1) de LED selon l'une des revendications 1 à 27 ou d'un ensemble multiple selon l'une des revendications 28 à 34 pour la formation de lumière blanche mélangée,
**caractérisée en ce que**
l'emplacement de couleur de la lumière mélangée est défini par le courant de fonctionnement des corps semi-conducteurs (11) de LED.

36. Utilisation selon la revendication 35, **caractérisée en ce que** les corps semi-conducteurs (11) de LED présentant la même longueur d'onde centrale sont alimentés par le même courant de fonctionnement.

37. Utilisation d'un module (1) de LED selon l'une des revendications 19 à 27 ou d'un ensemble multiple selon l'une des revendications 28 à 34 pour la formation de lumière blanche mélangée,
**caractérisée en ce que**
les fréquences des corps semi-conducteurs (11) de LED de même longueur d'onde centrale sont sélectionnées de telle sorte que pour une même alimentation en courant de tous les corps semi-conducteurs (11) de LED, de la lumière blanche mélangée soit formée.
